# EUROPEAN PATENT APPLICATION

(11) **EP 4 546 590 A2**
(43) Date of publication of application: **30.04.2025**
(21) Application number: 24203321.5
(22) Date of filing: 27.09.2024
(51) Int. Cl.: H02H 9/00, H03K 17/00

(54) **EFFICIENT CHARGING OF CAPACITIVE LOADS BASED ON AUTOMATIC TRANSITION AMONG MULTIPLE OVERLOAD PROTECTION THRESHOLDS**

(30) Priority: 23.10.2023 US 202318382776
(71) Applicant: STMicroelectronics International N.V., 1228 Plan-les-Ouates, Geneva (CH)
(72) Inventor: RAGONESE, Domenico, 95030 Tremestieri Etneo (Catania) (IT); MINIERI, Marco, 95127 Catania (IT); GRECO, Maurizio, 95021 Acicastello (Catania) (IT); MARANO, Vincenzo, 20092 Cinisello Balsamo (Milano) (IT); ELIAS, Vojtech, 15000 Prague (CZ); HOFMAN, Milos, 27322 Hospozin (CZ)
(74) Representative: Buzzi, Notaro & Antonielli d'Oulx S.p.A.

(57) **Abstract**

A power-management system (5) includes a power transistor (MN) coupled between a power supply (VCC) and a load (6), a driver circuit (8) driving the power transistor (MN) in response to an input signal (IN), and an error amplifier (9) generating a control signal (CTRL) that modifies operation of the driver circuit (8) based on a comparison between a selected reference voltage (Vds_ref) and a drain-to-source voltage (Vds) of the power transistor (MN). A multiplexer (10) provides the selected reference voltage (Vds_ref) to the error amplifier (9) and passes one of a plurality of different reference voltages (Vds(ref1), Vds(ref2), Vds(ref3), Vds(ref4)) as the selected reference voltage (Vds_ref) based upon first and second selection signals (Sel1, Sel2). A first selection circuit (13) charges a first capacitor (C1) in response to the input signal (IN) and generates the first selection signal (Sel1) based on a first voltage (V1) across the first capacitor (C1). A second selection circuit (23) charges a second capacitor (C2) in response to the input signal (IN) and generates the second selection signal (Sel2) based on a second voltage (V2) across the second capacitor (C2).

## Description

### TECHNICAL FIELD

This disclosure relates to the technical field of power electronics, specifically focusing on the dynamic management of charging capacitive loads through automatic transitioning among various overload protection thresholds.

### BACKGROUND

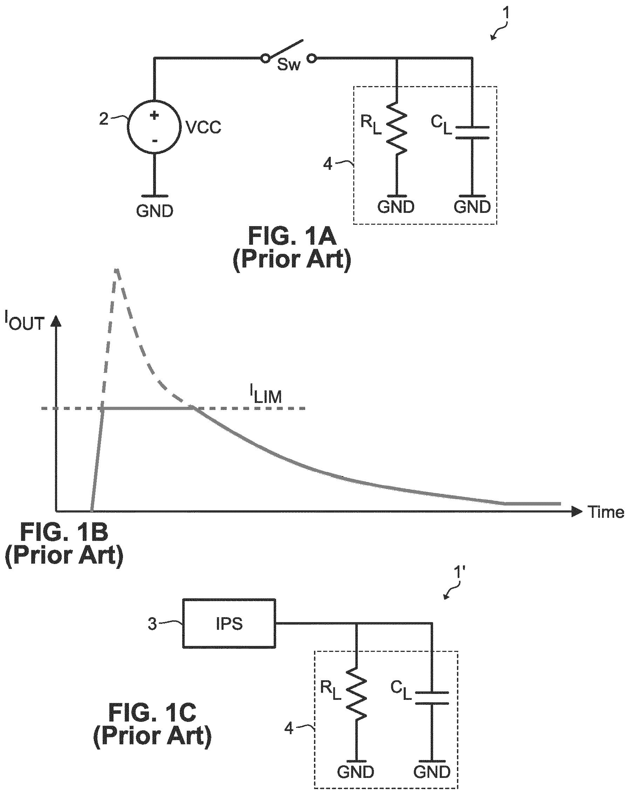

As a capacitive load 4 shown in FIG. 1, represented by load resistance R_{L} and load capacitance C_{L} begins to charge, it emulates the behavior of a short circuit. This is illustrated in FIG. 1A which depicts power system 1 where a voltage source 2 is connected between ground and a switch Sw. The switch Sw is positioned between the voltage source 2 and the capacitive load 4. As the charge within the capacitive load 4 rises, the voltage across the capacitive load 4 similarly rises, leading to a corresponding decrease in the load current I_{OUT} delivered to the capacitive load.

This inherent behavior introduces a challenge at the instant of switch-on, referred to as inrush current. Inrush current is the initial surge of current I_{OUT} observed when power is first applied to the capacitive load 4. This surge can be many times higher than the steady-state current the system 1 is designed to handle. Without proper overload (OVL) protection, this inrush current I_{OUT} can lead to component damage, reduced system reliability, and other potential hazards.

FIG. 1B serves to highlight this challenge. In the graph, the dashed lines show the uncontrolled output current I_{OUT} at switch-on in the absence of any OVL protection. Such a current profile presents a risk for a power system.

To address these concerns and provide a safer charging mechanism, power system 1' has been designed as shown in FIG. 1C. Here, a power supply 3 having OVL protection is connected to the capacitive load 4. This system 1' takes a proactive approach against the challenges posed by inrush currents. The graph in FIG. 1B, represented by solid lines, demonstrates the output current I_{OUT} when the power supply 3 applies OVL protection, setting a current limit of I_{LIM}. This approach provides a controlled rise in current I_{OUT} to the current limit I_{LIM} and maintenance of that current I_{OUT} at I_{LIM} during the initial charging phase, effectively mitigating the risks associated with the inrush current at switch-on.

### SUMMARY

Disclosed herein is a power management system, including a power transistor coupled between a power supply and a load, with a driver circuit configured to drive the power transistor in response to an input signal. An error amplifier is configured to generate a control signal that controls the driver circuit based on a comparison between a selected reference voltage and a drain-to-source voltage of the power transistor. A multiplexer is coupled to provide the selected reference voltage to the error amplifier, the multiplexer being configured to pass one of a plurality of different reference voltages as the selected reference voltage based upon first and second selection signals. A first selection circuit is coupled to a first capacitor, the first selection circuit being configured to charge the first capacitor in response to the input signal and generate the first selection signal based on a first voltage across the first capacitor. A second selection circuit is coupled to a second capacitor, the second selection circuit being configured to charge the second capacitor in response to the input signal and generate the second selection signal based on a second voltage across the second capacitor.

The first selection circuit may include a first comparator configured to assert its output when the first voltage across the first capacitor is greater than the reference voltage, thereby asserting the first selection signal.

The second selection circuit may include a second comparator configured to assert its output when the second voltage across the second capacitor is greater than the reference voltage, thereby asserting the second selection signal.

A first current source may be associated with the first selection circuit, the first current source being configured to provide current to the first capacitor in response to the input signal being asserted.

The first selection circuit may include a first switch selectively coupled between the output of the first current source and the first capacitor, with the first switch being controlled based on the input signal.

A second current source may be associated with the second selection circuit, with the second current source being configured to provide current to the second capacitor in response to the input signal asserted.

The second selection circuit may also include a second switch selectively coupled between the output of the second current source and the second capacitor, with the second switch being controlled based on the input signal.

Also disclosed herein is a method for managing power in a system. The method may include receiving an input signal at a driver circuit, and driving a power transistor coupled between a power supply and a load, using the driver circuit and based on assertion of the received input signal. The method may further include comparing a selected reference voltage with a drain-to-source voltage of the power transistor, generating the control signal based on the comparison to modify operation the driver circuit when the drain-to-source voltage is less than the selected reference voltage, and selecting the selected reference voltage from one of a plurality of different reference voltages based upon first and second selection signals. The method further includes charging a first capacitor via a first selection circuit in response to the input signal, generating the first selection signal based on a first voltage across the first capacitor, charging a second capacitor via a second selection circuit in response to the input signal, and generating the second selection signal based on a second voltage across the second capacitor.

Generating the first selection signal may include comparing the first voltage across the first capacitor to a reference voltage and asserting the first selection signal when the first voltage is greater than the reference voltage.

Generating the second selection signal may include comparing the second voltage across the second capacitor to a reference voltage and asserting the second selection signal when the second voltage is greater than the reference voltage.

The method may include charging the first capacitor using a first current source associated with the first selection circuit when the input signal is asserted.

The method may include controlling a first switch, which is coupled between the output of the first current source and the first capacitor, based on the input signal to facilitate the charging of the first capacitor.

The method may include charging the second capacitor using a second current source associated with the second selection circuit when the input signal is asserted.

The method may include controlling a second switch, which is selectively coupled between the output of the second current source and the second capacitor, based on the input signal to facilitate the charging of the second capacitor.

### BRIEF DESCRIPTION OF THE DRAWINGS

FIG. 1A is a schematic block diagram of a prior art power system without overload protection.
FIG. 1B is a graph showing operation of the prior art power systems of FIGS. 1A and 1C.
FIG. 1C is a schematic block diagram of a prior art power system with overload protection.
FIG. 2 is a schematic block diagram of a power system disclosed herein.
FIG. 3 is a graph showing operation of the power system of FIG. 2.

### DETAILED DESCRIPTION

The following disclosure enables a person skilled in the art to make and use the subject matter described herein. The general principles outlined in this disclosure can be applied to embodiments and applications other than those detailed above without departing from the spirit and scope of this disclosure. It is not intended to limit this disclosure to the embodiments shown, but to accord it the widest scope consistent with the principles and features disclosed or suggested herein.

Note that in the following description, any resistor or resistance mentioned is a discrete device, unless stated otherwise, and is not simply an electrical lead between two points. Therefore, any resistor or resistance connected between two points has a higher resistance than a lead between those two points, and such resistor or resistance cannot be interpreted as a lead. Similarly, any capacitor or capacitance mentioned is a discrete device, unless stated otherwise, and is not a parasitic element, unless stated otherwise. Additionally, any inductor or inductance mentioned is a discrete device, unless stated otherwise, and is not a parasitic element, unless stated otherwise.

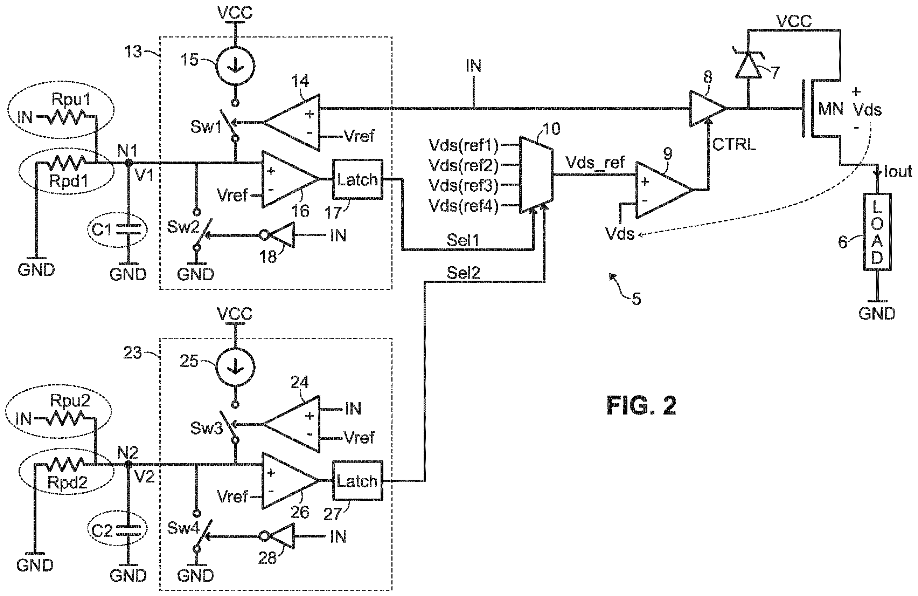

Now described with reference to FIG. 2 is a power system 5 including a power transistor MN connected between a power supply VCC and a load 6 to supply power to the load 6. The transistor MN is driven by a driver circuit 8 in response to an input signal IN, and a Zener diode 7 has its anode connected to the gate of transistor MN and has its cathode connected to the power supply VCC. The driver circuit 8 has its gain controlled by a control signal CTRL generated by an error amplifier 9 based on a comparison between a selected reference voltage Vds_ref and the drain-to-source voltage Vds of the power transistor MN. The selected reference voltage Vds _ref is provided at the output of the multiplexer 10. In particular, the multiplexer 10 passes one of four difference reference voltages Vds(ref1), Vds(ref2), Vds(ref3), Vds(ref4) as the output selected reference voltage Vds_ref based upon a two-bit signal formed by the single-bit selection signals Sel1, Sel2. The selection signal Sell is generated by a first selection circuit 13, and the selection signal Sel2 is generated by a second selection circuit 23.

The first selection circuit 13 includes a switch Sw1 connected between the output of current source 15 and node N1. Switch Sw1 is controlled by the output of comparator 14, which asserts its output (to close switch Sw1) when the input signal IN is greater than reference voltage Vref. Switch Sw2 is connected between node N1 and ground, with switch Sw2 being controlled by the output of inverter 18, which inverts the input signal IN. Therefore, collectively, switch Sw1 is closed (and switch Sw2 is opened) when the input signal IN is greater than the reference voltage Vref, and switch Sw2 is closed (and switch Sw1 is opened) when the input signal IN is at a logic low. Comparator 16 has its output connected to latch 17, and asserts its output when the voltage V1 at N1 is greater than the reference voltage Vref. The selection signal Sell is the output of the latch 17; therefore, when the output of the comparator 16 is asserted, the selection signal Sell is asserted, and when the output of the comparator 16 is deasserted, the selection signal Sel 1 is deasserted.

A capacitor C1 is connected between node N1 and ground. Instead of C1, a first pull-up resistor Rpu1 (e.g., 220 kS2) may be connected between the input signal IN and node N1, or a first pull-down resistor Rpd1 (e.g., 10 kΩ) may be connected between the ground and node N1, to statically set a level of voltage V1 at node N1.

The second selection circuit 23 includes a switch Sw3 connected between the output of current source 25 and node N2. Switch Sw3 is controlled by the output of comparator 24, which asserts its output (to close switch Sw3) when the input signal IN is greater than reference voltage Vref. Switch Sw4 is connected between node N2 and ground, with switch Sw4 being controlled by the output of inverter 28, which inverts the input signal IN. Therefore, collectively, switch Sw3 is closed (and switch Sw4 is opened) when the input signal IN is greater than the reference voltage Vref, and switch Sw4 is closed (and switch Sw3 is opened) when the input signal IN is at a logic low. Comparator 26 has its output connected to latch 27, and asserts its output when the voltage V2 at N2 is greater than the reference voltage Vref. The selection signal Sel2 is the output of the latch 27; therefore, when the output of the comparator 26 is asserted, the selection signal Sel2 is asserted, and when the output of the comparator 26 is deasserted, the selection signal Sel2 is deasserted.

A capacitor C2 is connected between node N2 and ground. Instead of C2, a second pull-up resistor Rpu2 (e.g., 220 kS2) may be connected between the input signal IN and node N2, or a second pull-down resistor Rpd2 (e.g., 10 kΩ) may be connected between the ground and node N2, to statically set a level of voltage V2 at node N2.

The difference between the second selection circuit 23 and first selection circuit 13 is the value of the capacitances C1 and C2, in particular, C1 being smaller than C2. The purpose for this will be explained below.

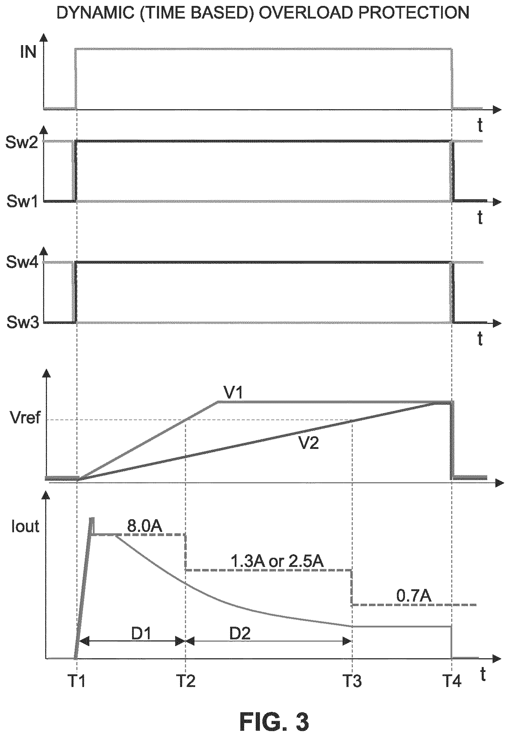

Operation is now described with additional reference to FIG. 3. Switch-on occurs at time T1, and an inrush output current Iout flows into the load 6. Simultaneously, the input signal IN rises to a logic high. At this instant, the voltages V1 and V2 are both less than Vref, leading to the outputs of comparators 16 and 26 remaining at a logic low. This state is stored by latches 17 and 27. As a consequence, both selection signals Sel1 and Sel2 are logic zero. This configures the multiplexer 10 to select its first input, relaying the voltage Vds(ref1) to the non-inverting input of the error amplifier 9 as Vds_ref.

At the moment when switch-on occurs, the drain to source voltage Vds of the transistor MN is below Vds_ref. The error amplifier 9, detecting this difference, asserts the control signal CTRL to a logic high, not restricting operation of the driver 8. In response to the logic high input signal IN, the driver 8 activates the transistor MN, allowing a high inrush current to act as the output current Iout. However, shortly after T1, this surge causes the drain to source voltage Vds of the transistor MN to rise above Vds_ref (which is Vds(ref1) at this point). As a result, the error amplifier 9 deasserts the control signal CTRL, modifying operation of the driver 8 by modifying the gate to source voltage of the transistor MN to limit the current through transistor MN. This ensures that the output current Iout does not exceed a predefined first current limit (e.g., 8.0 A). As the capacitive load 6 charges up, its increasing voltage causes a decrease in the Vds of the transistor MN, which can be clearly seen in FIG. 3 shortly after the high inrush current is limited and before T2.

In parallel, the logic high state of the input signal IN leads comparators 14 and 24 to assert their outputs. This action closes switches Sw1 and Sw3. The inverters 18 and 28, inverting the state of the input IN, deassert their outputs, which opens switches Sw2 and Sw4. This allows current sources 15 and 25 to channel current to nodes N1 and N2, beginning the charging of capacitors C1 and C2. Consequently, the voltages V1 and V2 at these nodes rise. V1 increases faster than V2 due to the smaller size of capacitor C1 as compared to C2, which charges more quickly compared to C2.

By time T2, V1 rises to be greater than Vref. In response, comparator 16 asserts its output, which latch 17 then stores, causing selection signal Sell to switch to a logic high. This action alters the selection of the multiplexer 10 to its second input, now forwarding Vds(ref2) as Vds_ref to the error amplifier 9. As a result, the current limit for Iout is set to a second, lower value (e.g., 1.3 A or 2.5 A). Observe that as a result of the prior decrease in Vds, Iout remains below this second current limit, steadily decreasing as Vds continues to drop. Meanwhile, V2 has yet to exceed Vref, so Sel2 remains unasserted.

The charging process for capacitors C1 and C2 continues due to the uninterrupted current flow from sources 15 and 25. By time T3, V2 eventually exceeds Vref. Comparator 26, sensing this change, asserts its output. This state is stored by latch 27, causing Sel2 to switch to a logic high. This transition prompts the multiplexer 10 to select its third input, sending Vds(ref3) to the error amplifier 9 as Vds_ref. Consequently, the output current Iout is now limited to a third, even lower current limit (e.g., 0.7 A). Again, due to the previously described Vds decrease, Iout remains below this threshold, with its magnitude continuing to diminish as Vds reduces further.

In many electronic systems, especially those employing capacitive loads, managing the inrush current is of concern for maintaining both the performance and longevity of the components. The power system 5 provides various advantages. Firstly, it offers automatic transitions among different current limitation levels, removing the use of intervention by external control systems. This autonomic behavior not only simplifies the firmware running in the control system but also permits the selection of more cost-effective control systems with lower computational capability. Secondly, the power system 5 provides for the configurability of the active time window for each current limitation level, allowing for adaptability to varied system conditions. Lastly, it provides for a rapid yet safe charge of the capacitive load, striking a balance between system responsiveness and protection. The initial high current limit facilitates this rapid charging phase. However, continuing with such high currents might endanger components or lead to unwelcome system behaviors. As the system transitions to lower current limits, potential risks like overheating, electromagnetic interference, or power source stresses are mitigated. Thus, the power system 5 disclosed herein combines the benefits of quick response times with the safeguarding of system components.

It is evident that modifications and variations can be made to what has been described and illustrated herein without departing from the scope of this disclosure.

This disclosure is intended to encompass configurations that include more than the two selection circuits 13 and 23. Indeed, it is contemplated that additional selection circuits can be incorporated into the system to generate additional selection signals. By utilizing these added signals, a multiplexer 10 with a greater number of inputs may be used, extending beyond the current four. This offers the flexibility to tailor the power management system for various applications desiring larger numbers of current limitation levels. Also understand that by varying the capacitance value of the respective capacitors linked to each individual selection circuit, it becomes possible to precisely adjust the timing between transitions to these different current limit levels. This capacitive adjustment provides for fine-tuning of the system response to suit specific applications, providing for both rapid and safe charging operations.

Although this disclosure has been described with a limited number of embodiments, those skilled in the art, having the benefit of this disclosure, can envision other embodiments that do not deviate from the disclosed scope. Furthermore, skilled persons can envision embodiments that represent various combinations of the embodiments disclosed herein made in various ways.

## Claims

1. A power management system (5), comprising:
a power transistor (MN) coupled between a power supply (VCC) and a load (6);
a driver circuit (8) configured to drive the power transistor (MN) in response to an input signal (IN);
an error amplifier (9) configured to generate a control signal (CTRL) that controls the driver circuit (8) based on a comparison between a selected reference voltage (Vds_ref) and a drain-to-source voltage (Vds) of the power transistor (MN);
a multiplexer (10) coupled to provide the selected reference voltage (Vds_ref) to the error amplifier (9), the multiplexer (10) configured to pass one of a plurality of different reference voltages (Vds(refl), Vds(ref2), Vds(ref3), Vds(ref4)) as the selected reference voltage (Vds_ref) based at least upon a first selection signal (Sel1);
a first selection circuit (13) coupled to a first capacitor (C1), wherein said first selection circuit (13) is configured to charge the first capacitor (C1) in response to the input signal (IN) and generate the first selection signal (Sel1) based on a first voltage (V1) across the first capacitor (C1).

2. The power management system (5) of claim 1, wherein the first selection circuit (13) includes a first comparator (16) configured to assert its output when the first voltage (V1) across the first capacitor (C1) is greater than the reference voltage (Vref), thereby asserting the first selection signal (Sel1).

3. The power management system (5) of claim 1, further comprising a first current source (15) associated with the first selection circuit (13), the first current source (15) configured to provide current to the first capacitor (C1) in response to the input signal (IN) being asserted.

4. The power management system (5) of claim 3, wherein the first selection circuit (13) further comprises a first switch (Sw1) selectively coupled between the output of the first current source (15) and the first capacitor (C1), with the first switch (Sw1) being controlled based on the input signal (IN).

5. The power management system (5) of claim 1, wherein the multiplexer (10) is configured to pass one of the plurality of different reference voltages (Vds(refl), Vds(ref2), Vds(ref3), Vds(ref4)) as the selected reference voltage (Vds_ref) based further upon a second selection signal (Sel2), the power management system (5) further comprising a second selection circuit (23) coupled to a second capacitor (C2), wherein the second selection circuit (23) is configured to charge the second capacitor (C2) in response to the input signal (IN) and generate the second selection signal (Sel2) based on a second voltage (V2) across the second capacitor (C2).

6. The power management system (5) of claim 5, wherein the second selection circuit (23) includes a second comparator (26) configured to assert its output when the second voltage (V2) across the second capacitor (C2) is greater than the reference voltage (Vref), thereby asserting the second selection signal (Sel2).

7. The power management system (5) of claim 5, further comprising a second current source (25) associated with the second selection circuit (23), the second current source (25) being configured to provide current to the second capacitor (C2) in response to the input signal (IN) asserted.

8. The power management system (5) of claim 7, wherein the second selection circuit (23) further comprises a second switch (Sw3) selectively coupled between the output of the second current source (25) and the second capacitor (C2), with the second switch (Sw3) being controlled based on the input signal (IN).

9. A method for managing power in a system (5), the method comprising:
receiving an input signal (IN) at a driver circuit (8);
driving a power transistor (MN) coupled between a power supply (VCC) and a load (6), using the driver circuit (8) and based on assertion of the received input signal (IN);
comparing a selected reference voltage (Vds_ref) with a drain-to-source voltage (Vds) of the power transistor (MN);
generating the control signal (CTRL) based on the comparison to modify operation the driver circuit (8) when the drain-to-source voltage (Vds) is less than the selected reference voltage (Vds_ref);
selecting the selected reference voltage (Vds_ref) from one of a plurality of different reference voltages (Vds(refl), Vds(ref2), Vds(ref3), Vds(ref4)) based upon first and second selection signals (Sel1, Sel2);
charging a first capacitor (C1) via a first selection circuit (13) in response to the input signal (IN);
generating the first selection signal (Sel1) based on a first voltage (V1) across the first capacitor (C1);
charging a second capacitor (C2) via a second selection circuit (23) in response to the input signal (IN); and
generating the second selection signal (Sel2) based on a second voltage (V2) across the second capacitor (C2).

10. The method of claim 9, wherein generating the first selection signal (Sel1) comprises comparing the first voltage (V1) across the first capacitor (C1) to a reference voltage (Vref) and asserting the first selection signal (Sel1) when the first voltage (V1) is greater than the reference voltage (Vref).

11. The method of claim 9, wherein generating the second selection signal (Sel2) comprises comparing the second voltage (V2) across the second capacitor (C2) to a reference voltage (Vref) and asserting the second selection signal (Sel2) when the second voltage (V2) is greater than the reference voltage (Vref).

12. The method of claim 9, further comprising charging the first capacitor (C1) using a first current source (15) associated with the first selection circuit (13) when the input signal (IN) is asserted.

13. The method of claim 12, further comprising controlling a first switch (Sw1), which is coupled between the output of the first current source (15) and the first capacitor (C1), based on the input signal (IN) to facilitate the charging of the first capacitor (C1).

14. The method of claim 9, further comprising charging the second capacitor (C2) using a second current source (25) associated with the second selection circuit (23) when the input signal (IN) is asserted.

15. The method of claim 14, further comprising controlling a second switch (Sw3), which is selectively coupled between the output of the second current source (25) and the second capacitor (C2), based on the input signal (IN) to facilitate the charging of the second capacitor (C2).
